# EUROPEAN PATENT APPLICATION

(11) **EP 3 913 435 A1**
(43) Date of publication of application: **24.11.2021**
(21) Application number: 20175361.3
(22) Date of filing: 19.05.2020
(51) Int. Cl.: G03F 7/20, G06N 5/04

(54) **CONFIGURATION OF AN IMPUTER MODEL**

(71) Applicant: ASML Netherlands B.V., 5500 AH Veldhoven (NL)
(72) Inventor: SAHRAEIAN, Reza, 5500 AH Veldhoven (NL); BASTANI, Vahid, 5500 AH Veldhoven (NL); GKOROU, Dimitra, 5500 AH Veldhoven (NL); DOS SANTOS GUZELLA, Thiago, 5500 AH Veldhoven (NL)
(74) Representative: ASML Netherlands B.V.

(57) **Abstract**

Apparatus and methods of configuring an imputer model for imputing a second parameter. The method comprises inputting a first data set comprising values of a first parameter to the imputer model, and evaluating the imputer model to obtain a second data set comprising imputed values of the second parameter. The method further comprises obtaining a third data set comprising measured values of a third parameter, wherein the third parameter is correlated to the second parameter; obtaining a prediction model configured to infer values of the third parameter based on inputting values of the second parameter; inputting the second data set to the prediction model, and evaluating the prediction model to obtain inferred values of the third parameter; and configuring the imputer model based on a comparison of the inferred values and the measured values of the third parameter.

## Description

### FIELD

The present invention relates to apparatus for and methods of configuring an imputer model for imputing a parameter. Specifically, the model may impute a second parameter based on a first parameter, and the configuration of the model takes into account a third parameter correlated to the second parameter.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-kl lithography may be used to process features with dimensions smaller than the classical resolution limit of a lithographic apparatus. In such process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Lithographic processes may generate a lot of data, which may be analysed to monitor and/or control the apparatus. The data may be generated by for example sensors in the lithographic apparatus itself, or metrology data of measurements performed on substrates patterned by the lithographic apparatus. The processing of such large amounts of data relating to complex processes may involve the use of models. The models may be machine learning models, for example neural networks. A model may estimate an output based on a provided input. Before it can provide an output, the model has to learn about the lithographic process. In order to do so, machine learning models need to be trained. Training may be performed on a training data set. Training data sets may comprise known (historic) values of both the input and output of the model. Obtaining a training data set may be difficult, as data values of the output may not be commonly available, and/or input data sets for which output data is available may not be complete (e.g. some input data values may be missing). The methods and apparatus described herein aim to address the challenge of finding suitable training data.

### SUMMARY

It is an object of the present invention to provide methods and apparatus for configuring an imputer model for imputing a second parameter.

According to a first aspect of the disclosure, there is provided a method of configuring an imputer model for imputing a second parameter. The method comprises inputting a first data set comprising values of a first parameter to the imputer model. The imputer model is evaluated to obtain a second data set comprising imputed values of the second parameter. A third data set is obtained comprising measured values of a third parameter, wherein the third parameter is correlated to the second parameter. A prediction model is obtained, configured to infer values of the third parameter based on inputting values of the second parameter. The second data set is input to the prediction model, and the prediction model is evaluated to obtain inferred values of the third parameter. The imputer model is configured based on a comparison of the inferred values and the measured values of the third parameter.

Optionally, the method may further comprise obtaining an analysis model configured to output a mask vector estimating whether received input values are imputed or known. At least the second data set may be input to the analysis model. The analysis model may be evaluated to obtain a mask vector with an estimate whether the second data set comprises imputed data. Configuring the imputer model may further be based on the output of the analysis model.

Optionally, inputting at least the second data set to the analysis model may further comprise inputting at least one of the first data set and the third data set.

Optionally, the first data set may comprise a plurality of parameters.

Optionally, the first, second, and third parameters may be related to a lithographic patterning process.

Optionally, the first data set may comprise at least one of levelling data, alignment data, and/or overlay data.

Optionally, the second parameter may be one of overlay or critical dimension.

Optionally, the third parameter may be yield.

Optionally, the imputer model may be configured to estimate the second data set for at least one of computational metrology and yield aware prediction.

Optionally, the prediction model and the imputer model may be trained simultaneously.

Optionally, at least one of the models may be a machine learning model.

Optionally, the machine learning model may comprise a deep neural network.

According to another aspect of the disclosure there is provided a method of determining an adjustment to a lithographic apparatus. The method comprises obtaining an imputer model that has been configured using a method as described above. A first data set relating to a previous lithographic exposure by the lithographic apparatus is input to the imputer model, and the imputer model is evaluated to obtain a second data set comprising estimated values of a second parameter. The second data set is input to a target prediction model, and the target prediction model is evaluated to obtain a third data set comprising inferred values of a third parameter. The adjustment to the lithographic apparatus is determined based on the inferred values of the third parameter.

Optionally, the method may further comprise implementing the determined adjustment to the lithographic apparatus for a subsequent lithographic exposure.

The target prediction model may be the same model as the prediction model used in the method of configuring the imputer model, or it may be a separate model.

According to another aspect of the disclosure, there is provided an apparatus for configuring an imputer model for estimating a second parameter. The apparatus comprises one or more processors and a non-transitory storage medium comprising instructions that, when executed, cause the processor to perform a method described above.

According to another aspect of the disclosure there is provided an apparatus comprising an imputer model configured using a method described above.

According to another aspect of the disclosure there is provided a metrology apparatus comprising an apparatus as described above.

According to another aspect of the disclosure there is provided a lithographic cell comprising an apparatus ad described above.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a flow diagram of steps in a method of configuring an imputer model;
- Figure 5 depicts a schematic diagram of an example application of an imputer model for yield prediction;
- Figure 6 depicts a schematic diagram of a training configuration of an imputer model comprising a prediction model;
- Figure 7 depicts a schematic diagram of a training configuration of an imputer model comprising a prediction model and an analysis model;
- Figure 8(a) depicts a graph showing a comparison of a predicted yield and a measured yield using an imputer model using the yield-aware training method described herein;
- Figure 8(b) depicts a graph showing a comparison of a predicted yield and a measured yield using a imputer model trained without yield-aware training.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

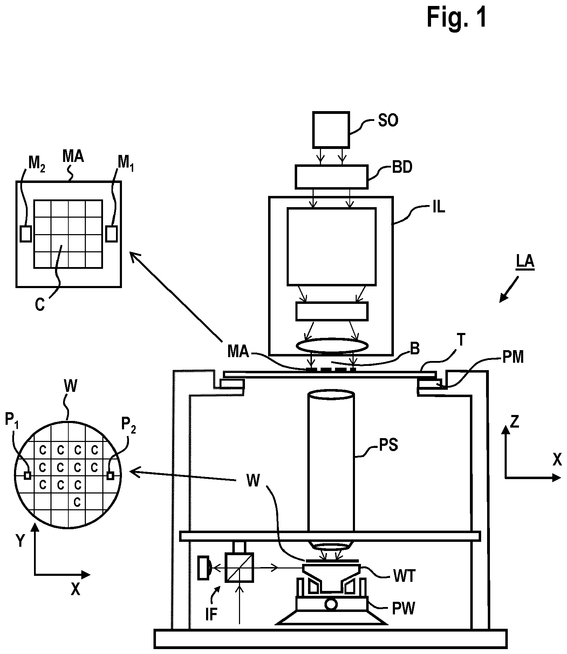

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

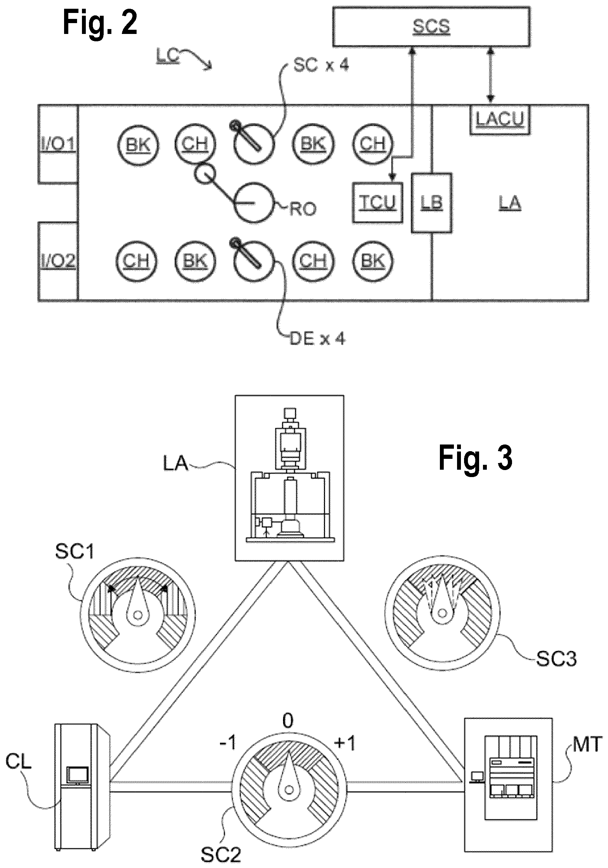

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Metrology tools MT may measure a substrate during different stages of the lithographic patterning process. Metrology of a substrate may be used for different purposes. Measurements of a substrate may for example be used for monitoring and/or updating lithographic process settings, error detection, analysis of the apparatus over time, quality control etc. Some measurements are easier to obtain than others. For example, some measurements may require specific target structures present on a substrate. Some measurements may take a relatively long time to perform compared to other measurements. Long measurements may take up a lot of time in expensive metrology tools MT. This may make those measurements expensive in terms of equipment use and time. As a result, such measurements may be performed less frequently. This may mean that only sparse measurement data is available for some parameters, and/or that the measurements may not be performed on every substrate.

The limited availability of measurement data for some parameters may pose a problem. Such measurement data may be useful for some of the purposes described above. As an example, it may be expensive to obtain metrology data for overlay. Overlay may therefore only be sparsely available for some or all patterned substrates. Overlay may be a useful parameter to act as a quality indicator for the lithographic process settings, and/or to predict yield on a substrate. In particular, overlay may be a better indicator of quality or yield than some other parameters that may be more straightforward to obtain from the available metrology data of, for example levelling data.

To address a limited availability of a parameter, such as overlay, models may be used to estimate values of that parameter, based on other available metrology data. In an example, overlay on a substrate may be estimated based on levelling data and/or alignment data. The models for estimating parameter values may be data driven. Data driven models may be used to estimate and/or predict parameter values and other properties (e.g. yield) of substrates and other aspects of a lithographic patterning process. Models may for example be used in computational metrology, yield aware control, and/or substrate level control of a lithographic apparatus LA. Models may use measurement data as input. Measurement data may comprise for example one or more of overlay OVL, levelling LVL, alignment AL, thickness, critical dimensions CD, dose map, focus map, and/or process context data. Examples of measurements include after development inspection (ADI), after etch inspection (AEI) and/or after cleaning inspection (ACI) measurements of overlay and/or levelling.

A problem with the models described above may be that they rely on the availability of the input parameters. Models may expect a similar amount and type of input for each evaluation. However, different types and density of measurements may be available for different substrates. For example, as production volume is ramped up, the measurement capacity per substrate may be reduced. In some cases, some measurements may be only be performed on a subset of all patterned substrates, to test a sample of the throughput. As a result, different amounts and/or types of measurement data may be available for different substrates. Several methods are known to deal with the differences in availability of parameter data. A first option is to disregard substrates which do not have all of the required data values. Alternatively or additionally, in order to be applicable to the data sets for more substrates, models may be designed to receive a smaller amount of input data so that more substrate data sets comprise the required input data for the model. However, this may mean a large amount of available data for some substrates is left unused, which may lead to less accurate predictions/estimates. A second option in which models can deal with the limitations in available data for some substrates, is to use statistics or models to estimate the missing data, for example based on the available data in the set. This may be the case for example in computational metrology. For example, a model may be provided to estimate dense overlay across a substrate, based on other available data, including one or more of levelling data, alignment data, and sparse overlay data. Next to statistics and modelling, interpolation may also be used to estimate an increased density of parameter values. In yet another example, historical data of a parameter, e.g. from a previously exposed substrate, may be used as an approximation of the parameter for a current substrate.

In one example, it may be an aim to predict a target, for example yield loss, of a lithographic patterning process using a target prediction model, for example a yield prediction model. Overlay OVL may be a good indicator to base a yield loss prediction on. Critical dimension CD may also be used, as it may have a high correlation to yield of a substrate. In order to make a precise and accurate prediction for a substrate, the yield prediction model may require both overlay data and critical dimension data for that substrate. In order to provide more accurate predictions, dense overlay data may be required for at least some layers on a substrate. However, overlay measurements may not be available for all required layers on a substrate. Furthermore, critical dimension CD data, may only be available sparsely and/or with coarse resolution. Different amounts of measurement data for different parameters may be available for different substrates. If a yield prediction model expects the same type and amount of input parameter data (e.g. a particular density of overlay and critical dimension data) for every evaluation, substrates for which only some of the parameter data is available cannot be evaluated by the yield prediction model. A separate model may therefore be provided to infer values of one or more parameters for which data values may not be available for every substrate. This separate model may be an imputer model, configured to infer values of a missing parameter based on known values of one or more other parameters. Improving the performance of the imputer model for estimating a missing parameter for an application, may lead to an improved result for that application.

The performance of a model output may depend on the quality of the input provided to the model. The quality of the output may also depend on the quality of the model itself. The quality of the model may be affected by the training of the model. That is to say, a model may be configured based on a training data set. The model may learn to predict an output based on an input using a training process. A training set may comprise data values of the input and data values of the output. During training a model may estimate an output, which may be compared to the known data values of the output. The comparison of the estimated and the known output values may be seen as an indicator of the quality of the output. The outcome of the comparison may be provided as feedback to the model, which may be updated. This process may be iterated to train the model. Improving the training of a model may lead to an improvement of its performance in estimating an output.

A problem with training an imputer model using the training method described above, may be that the model is target agnostic. That is to say, the imputer model is used in a step of a process of predicting a target, but this target is not taken into account during training. As the output of the imputer model is used for target prediction, the output and the target may be correlated. The inventors have realised that the correlation between the output and the target may be relevant and informative. Using available information from this correlation in the training process of the imputer model may provide an improvement in the training process. Furthermore, the correlation between the output parameter(s) and the target parameter(s) may only be partial. That is to say, some aspects to the output parameter(s) may have no or a limited effect on the target parameter(s). For example, the overlay in some layers or areas of a substrate may be less critical than overlay in other layers or areas on a substrate. If an imputer model is configured to determine an output that is in turn used to estimate a target, it may be beneficial to use the capacity of the imputer model to estimate those aspects of the output parameter(s) that are correlated to and/or affect the target.

Another problem with training and using imputer models as described above, is that some parameters may be difficult to estimate based on known parameter values. For example, critical dimension Cd may be strongly correlated to the yield of a substrate. However, it may only be weakly dependent on known parameter values. Therefore, it may be difficult to train an imputer model to estimate critical dimension CD based on available input parameters.

The imputer models described herein may be used during operation of the lithographic process. Providing an output may be time-sensitive, for example, it may be desirable to obtain an output for a current lithographic patterned substrate before the start of patterning of the next lithographic substrate. It may be desirable to obtain an imputer model output as quickly as possible, for example so that the results of the output may be used to improve future lithographic exposures. However, during the training of a model, this time-limited data element is not present. The removal of the time-sensitive element may be exploited during the training process. This may be achieved by using measurement data of a substrate in the training of the model that is not available as input during regular use of the model. Described herein are methods that use a correlation between an output of a model and a parameter not included in the input of the model, for training the model.

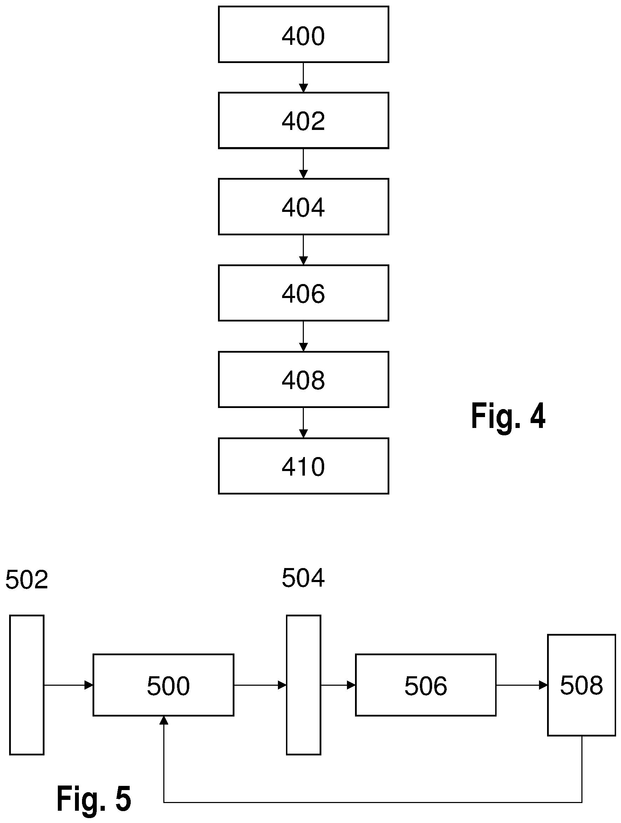

Figure 4 depicts a flow diagram showing steps in a method of training/configuring an imputer model. The imputer model may be for imputing a parameter to be provided as an output by the model. In step 400 a first data set comprising values of a first parameter is input to the imputer model. The first parameter may also be referred to as an input parameter. In step 402, the imputer model is evaluated to obtain a second data set comprising imputed values of the output parameter. The output parameter may also be referred to as the second parameter, as its determination is based on the first parameter. The second data set may similarly be referred to as an output data set. In step 404 a third data set may be obtained. The third data set comprises measured values of a third parameter. The third parameter is correlated to the second parameter. In step 406 a prediction model is obtained. The prediction model is different from the imputer model. The prediction model may be configured to receive values of the second parameter as input. Based on the received input, the prediction model may provide inferred values of the third parameter as output. In step 408 the second data set is input to the prediction model, and the prediction model is evaluated to obtain inferred values of the third parameter. In step 410 the imputer model is configured based on a comparison of the inferred values and the measured values of the third parameter.

An advantage of the method described in relation to figure 4 is that it can use the information comprised within the third parameter to train the imputer model. It may exploit the existing correlation between the output parameter and the third parameter to estimate values of the output parameter using known values of the third parameter. Due to the correlation between the output parameter and the third parameter, the training of the imputer model may be improved, as more data relating to the output parameter is used in the training process.

An advantage of being able to rely on information comprised in the third parameter for estimating the output parameter, may be that input data sets with less available data values may be used. For example, input data sets with a more sparse data value distribution may be used for training, as they may comprise sufficient information in combination with the third data set for providing an estimation of the second parameter. This may make it possible to train the imputer model using a larger data set. Alternatively or additionally, it may be easier to obtain training data sets for configuring the imputer model, due to the less stringent requirements on density of available input data.

The third parameter may be a parameter that is not provided as input to the imputer model. The third parameter may be unavailable as input for the imputer model. This may be for example because the third parameter may not be readily available at the time of evaluating the imputer model during normal use. The third parameter may be a target parameter of the output parameter. That is to say, during the normal intended use of the imputer model, a purpose of the output parameter may be to estimate the third parameter.

The imputer model may be used to impute values of a parameter for which no or sparse measurement data is available. The input parameter may be a parameter for which a lot of data values are available. The data may be available in a dense distribution across a substrate for a plurality of substrates. The output parameter may be referred to as a missing parameter, as it may be imputed to address a limited availability of the parameter in metrology data.

The method will now be described in more detail in relation to a lithographic patterning process of a substrate. However, the method may also be applied to other processes and fields in which parameter data sets with relationships and correlations as set out above are available. Figure 5 depicts a diagram of an example application in which an imputer model described herein may be used. The example application may comprise predicting the yield of a substrate patterned using a lithographic apparatus LA. An input data set, also referred to as a first data set, comprising values of one or more input parameters 502 may be provided to an imputer model 500. The input parameters 502 may be manufacturing process parameters of the lithographic patterning process. The imputer model 500 may provide an output data set, also referred to as a second data set, comprising estimated values of one or more output parameters 504. The output data set 504 is provided as an input to a target prediction model 506, also referred to as a yield prediction model. The yield prediction model 506 may predict a target data set, also referred to as a third data set, of one or more target parameters 508. The target parameter(s) may for example comprise the yield of the substrate. The first, second, and third data sets may comprise values of parameters of a lithographic apparatus LA, metrology tool MT, or other apparatus or process relating to a lithographic patterning process. The target prediction model may be the same model as the prediction model used for configuring the imputer model. The target prediction model may be a different model to the prediction model used for configuring the imputer model.

The target prediction model may prefer to use the one or more output parameters of the imputer model because they are a good indication of the target parameter. In a specific example, the input parameters 502 may comprise levelling data, alignment data, and/or sparse overlay data. The output parameters 504 may comprise dense overlay data. The parameters 504 may comprise critical dimension CD. The target prediction model 506 may be a yield prediction model. The input to the yield prediction model may comprise the dense overlay OVL and/or the critical dimension CD estimated by the imputer model 500. The input to the yield prediction model may for example further comprise critical dose data values. The output of the yield prediction model may comprise an estimated yield of finished dies on the substrate for which the input data 502 was provided.

In one embodiment, the input data set may comprise a sparse distribution of values of one or more output parameters. In another embodiment, the input data set may comprise no values of the output parameter. In both embodiments, values of the output parameter are considered to be missing. Next to one or more output parameters, the input to the target prediction model may comprise other data values. The model output may provide estimated values of the missing parameter to be used in an application.

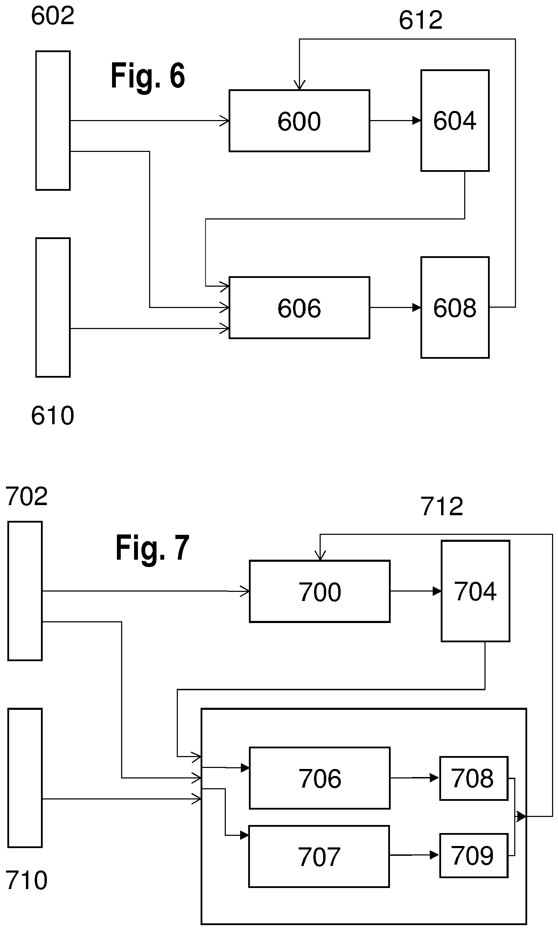

Figure 6 depicts a schematic overview of a training configuration according to an embodiment of the invention. During training a first data set of input data 602 may be provided to imputer model 600. The imputer model may estimate an output, comprising a second data set of a second parameter 604. As with a standard training of a model, the estimated output 604 may be compared to the known training values of the second parameter. The results of the comparison may be fed back to the imputer model 600, for updating the imputer model 600. The output of the imputer model 600 comprising the second data set 604 may further be provided as an input to prediction model 606. The prediction model 606 may further take input data set 602 as an input. Based on the received second data set 604, the prediction model may infer a third data set 608 comprising values of the third parameter. As mentioned above, the third parameter and the second parameter are correlated. The estimated third parameter may then be compared to the known, measures, values of the third parameter 610, which are also provided alongside the prediction model during the training process. The comparison may be seen as a measure of the quality of the estimated second parameter provided to the prediction model 606. The results of the comparison between inferred and measured third parameter values may be provided as feedback 612 to the imputer model 600. This feedback from the prediction model may be used alongside the results of the estimated output to the known output to update the imputer model. This process may be repeated a plurality of time to configure the imputer model 600.

As described above, the output of the imputer model 600 to be trained may be tested by the prediction model 606. The prediction model uses the correlation between the second parameter 604 output by the imputer model 600 and the third parameter. By feeding back 612 an assessment of the quality of the second data set 604 provided to the prediction model 606, the correlation between the second parameter and the third parameter is introduced into the training process of the imputer model 600. This allows the imputer model 600 to be trained using the correlation between the second and third parameters, without the third parameter being included in the imputer model itself.

In some cases, the imputer model 600 and the prediction model 608 may be trained simultaneously. In other instances, the prediction model may be trained separately, before being used in the training process of the imputer model 600. A separate training process of the prediction model 606 may have an effect on the imputer model 600. Training the prediction model 606 and the imputer model 600 together may have an advantage of avoiding such a potentially negative influence. This may be because the training of the prediction model 606 is included in the feedback process to optimise the imputer model 600.

Next to a prediction model, an analysis model may be provided as part of the configuration process of the imputer model. An analysis model may receive as input a plurality of data values. The analysis model may provide an output comprising a mask vector with an estimation whether the data values are imputed or known (e.g. measured). The plurality of data values may be of one or more data sets relating to one or more parameters. Figure 7 depicts a schematic overview of a training configuration in which an analysis model 707 is included. A lot of the setup is similar to the setup of figure 6. A first data set of input data 702 may be provided to imputer model 700 to be trained. The imputer model 700 may output a second data set with estimated values of a second parameter 704. This output 704 may be provided as input to prediction model 706, alongside input data 702. A third data set 708 may be inferred and compared to known values 710 of the third parameter, as described above. The second data set 704 may also be provided as input to analysis model 707. Analysis model 707 may further receive first data set 702 as input. The analysis model 707 may also receive known third parameter values 710 as input. The analysis model may be evaluated to provide a mask vector with an estimate on whether the values in the received data sets are imputed or known. This output may be compared to the known training data. That is to say, it may be assessed whether the analysis model 707 accurately estimated whether the second data values were imputed or not. Whether the analysis model 707 can recognise second data set values 704 as imputed or not may be seen as an indication of the quality of the estimated second data set. The worse the analysis model performs, the better the performance of the imputer model 700. This is in contrast to the prediction model 706, where a better performance of the prediction model 706 may indicate a better performance of the imputer model 700. The outputs 708, 709 of the prediction model 706 and analysis model 707 may be provided as feedback 712 to the imputer model 700.

As with the prediction model 706, in some embodiments, the analysis model 707 may be trained simultaneously with the imputer model 700. In other instances, the analysis model may have been trained separately, before being used in the configuration process of imputer model 700. All of the imputer model 700, prediction model 706, and analysis model 707 may be trained separately, or two or more of the imputer 700, prediction 706, and analysis 707 models may be trained simultaneously, together. As described above, training the analysis model 707 and the prediction model 706 together with the imputer model 700 may have an advantage that their training is included in the optimisation process of the imputer model 700. This may avoid a potentially negative influence of a separate training process of the prediction 706 and/or analysis 707 model. As a result, training the models together may lead to better performance of the imputer model 700.

The first data set 602, 702 may comprise data values of one or more parameters. For example, the first data set may comprise values of at least one of levelling data, alignment data and/or sparse overlay data. The second data set 604, 704 may comprise data values of one or more parameters. For example, the second data set may comprise values of at least one of dense overlay data, and/or critical dimension data. The third data set 610, 710 may comprise data values of one or more parameters. For example, the third data set may comprise data values of at least one of yield data and/or focus data.

Some or all of the imputer model 600, 700, the prediction model 606, 706, and the analysis model 707 may be machine learning models. One or more of the machine learning models may comprise a neural network, such as a deep neural network. The imputer model 600, 700 and the analysis model 606, 707 may be configured as a Generative Adversarial Network (GAN), wherein the imputer model 600, 700 acts as a generative network and the analysis model 606, 707 as the discriminative network. That is to say, the imputer model 600, 700 may generate a second data set, and the analysis model 707 may evaluate the generated second data set. The evaluation may be provided as feedback to the imputer model 600, 700 for training. The prediction model 606, 706 may be a parametric model. The analysis model 707 may be a parametric model.

As described above, once trained, the imputer model may be used in applications related to analysis and control of a lithographic patterning process. The data set output by an imputer model may be used in computational metrology. For example, an imputer model may output an overlay data set, which may be used to estimate substrate yield using computational metrology. This may be used for example in yield-aware prediction. In response to an estimation or prediction of the yield of a patterned substrate, one or more settings of a lithographic patterning process may be adjusted for a subsequent exposure.

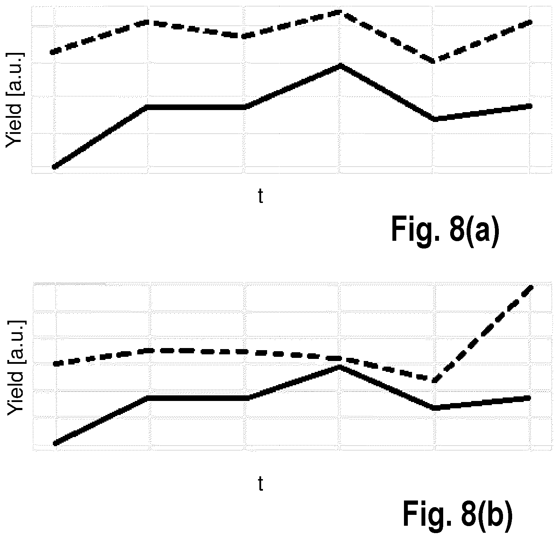

The configuration of an imputer model for estimating overlay and/or critical dimension based in input parameters and yield data not part of the model input, may be referred to as target-aware training, or yield-aware training of the imputer model. The yield-aware training of the imputer model may lead to overall better performance of the yield prediction application in which the imputer model is used. Figures 8(a) and 8(b) depict graphs with comparisons of measured and predicted yield for a substrate over time. Specifically, the graphs plot a yield loss over time. The measured yield (bottom curve) is the same in both graphs of figures 8(a) and 8(b). In figure 8(a) an estimated yield is plotted, wherein the yield was estimated using a method with a yield-aware imputer model. In figure 8(b) an estimated yield is plotted, obtain via a method not using a yield-aware imputer model. It is clear from the two graphs that the method of yield prediction using the target-aware imputer model leads to better prediction results.

Further embodiments are disclosed in the list of numbered clauses below:
1. A method of configuring an imputer model for imputing a second parameter, the method comprising:
   inputting a first data set comprising values of a first parameter to the imputer model, and evaluating the imputer model to obtain a second data set comprising imputed values of the second parameter;
   obtaining a third data set comprising measured values of a third parameter, wherein the third parameter is correlated to the second parameter;
   obtaining a prediction model configured to infer values of the third parameter based on inputting values of the second parameter;
   inputting the second data set to the prediction model, and evaluating the prediction model to obtain inferred values of the third parameter; and
   configuring the imputer model based on a comparison of the inferred values and the measured values of the third parameter.
2. A method according to clause 1, further comprising:
   obtaining an analysis model configured to output a mask vector estimating whether received input values are imputed or known; and
   inputting at least the second data set to the analysis model, and evaluating the analysis model to obtain a mask vector with an estimate whether the second data set comprises imputed data; and
   wherein configuring the imputer model is further based on the output of the analysis model.
3. A method according to clause 2, wherein inputting at least the second data set to the analysis model further comprises inputting at least one of the first data set and the third data set.
4. A method according to any of the preceding clauses, wherein the first data set comprises a plurality of parameters.
5. A method according to any of the preceding clauses, wherein the first, second, and third parameters are related to a lithographic patterning process.
6. A method according to clause 5, wherein the first data set comprises at least one of levelling data, alignment data, and/or overlay data.
7. A method according to any of clauses 5 - 6, wherein the second parameter is one of overlay or critical dimension.
8. A method according to any of clauses 5 - 7, wherein the third parameter is yield.
9. A method according to any of clauses 5 - 8, wherein the imputer model is configured to estimate the second data set for at least one of computational metrology and yield aware prediction.
10. A method according to any of the preceding clauses, wherein the prediction model and the imputer model are trained simultaneously.
11. A method according to any of the preceding clauses, wherein at least one of the models is a machine learning model.
12. A method according to clause 11, wherein the machine learning model comprises a deep neural network.
13. A method of determining an adjustment to a lithographic apparatus, the method comprising
   obtaining an imputer model that has been configured using a method according to any of clauses 1 - 12;
   inputting a first data set relating to a previous lithographic exposure by the lithographic apparatus to the imputer model, and evaluating the imputer model to obtain a second data set comprising estimated values of a second parameter;
   inputting the second data set to a target prediction model, and evaluating the target prediction model to obtain a third data set comprising inferred values of a third parameter; and
   determining the adjustment to the lithographic apparatus based on the inferred values of the third parameter.
14. A method according to clause 13, further comprising implementing the determined adjustment to the lithographic apparatus for a subsequent lithographic exposure.
15. An apparatus for configuring an imputer model for estimating a second parameter, the apparatus comprising one or more processors and a non-transitory storage medium comprising instructions that, when executed, cause the processor to perform a method according to any of clauses 1 - 14.
16. An apparatus comprising an imputer model configured using a method according to any of clauses 1 - 14.
17. A metrology apparatus comprising an apparatus according to any of clauses 15 - 16.
18. A lithographic cell comprising an apparatus according to any of clauses 15 - 16.
19. A method according to clause 2, wherein the analysis model and the imputer model are configured as a Generative Adversarial Network (GAN), wherein the imputer model is configured as a generative network and the analysis model as a discriminative network.
20. A method according to clause 2, wherein the prediction model and the analysis model are parametric models.

The methods described herein may be executed using one or more processors performing instructions saved in memory accessible by the processors. The processors may form part of a computer system CL forming part of a holistic lithographic system. Alternatively or additionally, the methods may be performed on a computer system separate from the lithographic system.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of configuring an imputer model for imputing a second parameter, the method comprising:
inputting a first data set comprising values of a first parameter to the imputer model, and evaluating the imputer model to obtain a second data set comprising imputed values of the second parameter;
obtaining a third data set comprising measured values of a third parameter, wherein the third parameter is correlated to the second parameter;
obtaining a prediction model configured to infer values of the third parameter based on inputting values of the second parameter;
inputting the second data set to the prediction model, and evaluating the prediction model to obtain inferred values of the third parameter; and
configuring the imputer model based on a comparison of the inferred values and the measured values of the third parameter.

2. A method according to claim 1, further comprising:
obtaining an analysis model configured to output a mask vector estimating whether received input values are imputed or known; and
inputting at least the second data set to the analysis model, and evaluating the analysis model to obtain a mask vector with an estimate whether the second data set comprises imputed data; and
wherein configuring the imputer model is further based on the output of the analysis model.

3. A method according to claim 2, wherein inputting at least the second data set to the analysis model further comprises inputting at least one of the first data set and the third data set.

4. A method according to any of the preceding claims, wherein the first data set comprises a plurality of parameters.

5. A method according to any of the preceding claims, wherein the first, second, and third parameters are related to a lithographic patterning process.

6. A method according to claim 5, wherein the first data set comprises at least one of levelling data, alignment data, and/or overlay data.

7. A method according to any of claims 5 - 6, wherein the second parameter is one of overlay or critical dimension.

8. A method according to any of claims 5 - 7, wherein the third parameter is yield.

9. A method according to any of claims 5 - 8, wherein the imputer model is configured to estimate the second data set for at least one of computational metrology and yield aware prediction.

10. A method according to any of the preceding claims, wherein the prediction model and the imputer model are trained simultaneously.

11. A method according to any of the preceding claims, wherein at least one of the models is a machine learning model.

12. A method according to claim 11, wherein the machine learning model comprises a deep neural network.

13. A method of determining an adjustment to a lithographic apparatus, the method comprising
obtaining an imputer model that has been configured using a method according to any of claims 1 -12;
inputting a first data set relating to a previous lithographic exposure by the lithographic apparatus to the imputer model, and evaluating the imputer model to obtain a second data set comprising estimated values of a second parameter;
inputting the second data set to a target prediction model, and evaluating the target prediction model to obtain a third data set comprising inferred values of a third parameter; and
determining the adjustment to the lithographic apparatus based on the inferred values of the third parameter.

14. A method according to claim 2, wherein the analysis model and the imputer model are configured as a Generative Adversarial Network (GAN), wherein the imputer model is configured as a generative network and the analysis model as a discriminative network.

15. A method according to claim 2, wherein the prediction model and the analysis model are parametric models.
